(19) Europäisches Patentamt
European Patent Office
Office européen des brevets

(11) EP 4 656 778 A1

(12) **EUROPEAN PATENT APPLICATION**
published in accordance with Art. 153(4) EPC

(43) Date of publication:
03.12.2025 Bulletin 2025/49

(51) International Patent Classification (IPC):
*C30B 29/04* (2006.01)    *C23C 16/27* (2006.01)
*C23C 16/511* (2006.01)    *C30B 25/02* (2006.01)

(21) Application number: 24747372.1

(22) Date of filing: 26.01.2024

(52) Cooperative Patent Classification (CPC):
C23C 16/27; C23C 16/511; C30B 25/02;
C30B 29/04

(86) International application number:
PCT/JP2024/002371

(87) International publication number:
WO 2024/158048 (02.08.2024 Gazette 2024/31)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.01.2023 JP 2023010113

(71) Applicant: Kyoto University
Kyoto-shi, Kyoto 606-8501 (JP)

(72) Inventors:
• MIZUOCHI, Norikazu
Kyoto-shi, Kyoto 606-8501 (JP)
• KAWASHIMA, Hiroyuki
Kyoto-shi, Kyoto 606-8501 (JP)
• KAWASE, Riku
Kyoto-shi, Kyoto 606-8501 (JP)

(74) Representative: Studio Torta S.p.A.
Via Viotti, 9
10121 Torino (IT)

(54) **METHOD FOR PRODUCING SYNTHETIC DIAMOND AND SENSOR ELEMENT**

(57) A method for producing synthetic diamond by chemical vapor deposition, the method comprising an introduction step of introducing a feed gas into a reaction vessel, and an activation step of chemically activating the feed gas, wherein the pressure in the reaction vessel during the activation step is 15 kPa or higher and equal to or lower than atmospheric pressure.

Fig. 7

EP 4 656 778 A1

**Description**

Technical Field

The present invention relates to a method for producing synthetic diamond by chemical vapor deposition.

Background Art

Due to its excellent optical, electrical, and thermal properties, diamond is expected to find applications in optical elements and electronic devices. In particular, the nitrogen-vacancy center (NV center) in diamond has attracted attention. The NV center is composed of nitrogen impurity inside the diamond and its adjacent vacancy defect, and exhibits magnetic properties called "electron spin" when electrons are captured in the vacancy. Because the electron spin in the NV center has a long coherence time even at room temperature, and the spin state is controllable and detectable at room temperature, diamond shows promise for application in quantum computing and highly sensitive quantum sensors, such as for magnetic and electric fields.

Synthetic diamond is a diamond that is artificially produced by science and technology, as opposed to diamond produced naturally. Compared to natural diamond, synthetic diamond has fewer impurities and crystal defects, so synthetic diamond is used in a wide range of industrial applications and is also used as a base for providing NV centers. Various methods are known for producing synthetic diamond, such as high-pressure and high-temperature (HPHT) methods, chemical vapor deposition (CVD), and detonation methods. For example, PLT 1 below discloses a method for producing synthetic diamond by the microwave plasma CVD method.

Citation List

Patent Literature

PTL 1: JP2009-196832A

Summary of Invention

Technical Problem

One of the indicators to evaluate the performance of NV centers in diamond is the spin coherence time $T_2$. For example, in the case of application in quantum sensors, quantum sensors with a longer spin coherence time $T_2$ have a higher sensitivity. However, various impurities are incorporated into synthetic diamond during diamond synthesis by chemical vapor deposition. Incorporation of impurities into synthetic diamond reduces the spin coherence time $T_2$, resulting in low sensitivity of quantum sensors. There is a demand for suppression of the incorporation of impurities into synthetic diamond in order to use NV centers in the synthetic diamond for quantum computing and high-sensitivity quantum sensors and to promote such applications.

The present invention aims to suppress the incorporation of impurities into synthetic diamond.

Solution to Problem

The present invention to achieve the above aim includes, for example, the following aspects.

Item 1.

A method for producing synthetic diamond by chemical vapor deposition, the method comprising:

an introduction step of introducing a feed gas into a reaction vessel; and
an activation step of chemically activating the feed gas,

wherein the pressure in the reaction vessel during the activation step is 15 kPa or higher and equal to or lower than atmospheric pressure.

Item 2.

The method for producing synthetic diamond according to Item 1, wherein in the introduction step, the total reactant gas to be introduced into the reaction vessel, including the feed gas, is introduced into the reaction vessel at a total flow rate of higher than 100 sccm.

Item 3.

The method for producing synthetic diamond according to Item 1 or 2, wherein the pressure in the reaction vessel during the activation step is 15 kPa or higher and 60 kPa or lower. Item 4.
The method for producing synthetic diamond according to Item 1, wherein the activation step includes generating a plasma region in the atmosphere of the feed gas.

Item 5.

The method for producing synthetic diamond according to Item 1, further comprising a dopant gas introduction step of introducing a dopant gas into the reaction vessel, the dopant gas containing phosphorus or nitrogen as a component.

Item 6.

A sensor element comprising synthetic diamond produced by the method according to any one of Items 1 to 5, the synthetic diamond containing one or more nitrogen-vacancy centers in a crystal structure thereof.

Advantageous Effects of Invention

The present invention can suppress the incorporation of impurities into synthetic diamond.

Brief Description of Drawings

Fig. 1 shows a cross-sectional view of a schematic structure of a CVD device used to produce synthetic diamond.
Fig. 2 shows a view of a schematic structure of a measurement system used to evaluate NV centers in synthetic diamond.
Fig. 3 shows a graph of measurement results according to Example 1 for each set of synthesis conditions, obtained by measuring the spin coherence time $T_2$ of NV centers generated in synthetic diamond produced.
Fig. 4 shows a schematic view of four layers of synthetic diamond formed on a substrate in Example 2.
Fig. 5 shows images of the inside of a reaction vessel, captured during formation of the four layers of the synthetic diamond in Example 2.
Fig. 6 shows a graph of measurement results according to Example 2, obtained by quantitatively measuring the impurity concentration in each of the four layers of the synthetic diamond produced by the secondary ion mass spectrometry (SIMS) method.
Fig. 7 shows a graph of measurement results according to Example 2, obtained by plotting the measurement results of the concentration of each impurity in the synthetic diamond for each pressure in the reaction vessel during diamond synthesis.
Fig. 8 shows a graph explaining the correlation between the nitrogen concentration and the spin coherence time $T_2$ of NV centers in diamond.

Description of Embodiments

The following describes in detail embodiments of the present invention with reference to attached drawings. In the following description and drawings, the same reference numerals indicate the same or a similar component; therefore, redundant descriptions of the same or similar components will be omitted.

Summary of Invention

According to a first aspect, the present invention provides a method for producing synthetic diamond by chemical vapor deposition. According to a second aspect, the present invention provides a sensor element comprising synthetic diamond produced by the method for producing synthetic diamond according to the first aspect.
The method according to an embodiment is a method for producing synthetic diamond by chemical vapor deposition, the method comprising an introduction step of introducing a feed gas into a reaction vessel, and an activation step of chemically activating the feed gas, wherein the pressure in the reaction vessel during the activation step is 15 kPa or higher and equal to or lower than atmospheric pressure.

In the method according to an embodiment, in the introduction step, the total reactant gas to be introduced into the reaction vessel, including the feed gas, is introduced into the reaction vessel at a total flow rate of higher than 100 sccm. More preferably, the flow rate of the total reactant gas to be introduced into the reaction vessel is 400 sccm or higher.

In the method according to an embodiment, the pressure in the reaction vessel during the activation step is 15 kPa or higher and 60 kPa or lower. More preferably, the pressure in the reaction vessel during the activation step is 25 kPa or higher and 50 kPa or lower.

In the method according to an embodiment, the activation step includes generating a plasma region in the atmosphere of the feed gas.

The method according to an embodiment further includes a dopant gas introduction step of introducing a dopant gas into the reaction vessel. More preferably, the dopant gas contains phosphorus or nitrogen as a component.

In the method according to an embodiment, the impurity whose incorporation is suppressed during diamond synthesis is nitrogen, and the resulting synthetic diamond is a synthetic diamond in which the spin coherence time $T_2$ of NV centers is improved because the incorporation of nitrogen exceeding the optimum amount is suppressed, and that is thus suitable for application in quantum computing and high-sensitivity quantum sensors.

In the conventional production of synthetic diamond by chemical vapor deposition, the incorporation of impurities has been suppressed by reducing the pressure in the reaction vessel to a relatively low pressure of about 5 kPa to about 15 kPa (the low vacuum range approaching the medium vacuum range). In contrast, in the method for producing synthetic diamond by chemical vapor deposition according to the present invention, the pressure in the reaction vessel during the activation step is increased compared to conventional methods so that the pressure reaches 15 kPa or higher and equal to or lower than atmospheric pressure (the low vacuum range approaching the atmospheric pressure). Such an increase in pressure in the reaction vessel to reduce the difference between the pressure in the reaction vessel and the atmospheric pressure (about 101.3 kPa) as described above enables suppression of the incorporation of impurities into synthetic diamond. In the case of the plasma CVD method, an increase in pressure in the reaction vessel increases the plasma density, making it possible to further improve the quality of synthetic diamond. Suppression of the incorporation of impurities into synthetic diamond extends the spin coherence time $T_2$, which serves as the performance evaluation indicator of NV centers. In the case of application in quantum sensors, this improves the sensitivity of the quantum sensors.

The impurities that are incorporated into synthetic diamond include, for example, nitrogen in the air that flows into the reaction vessel due to air leakage and elements (e.g., phosphorus) originating from the dopant gas attached to the reaction vessel. When the amount of nitrogen (N) exceeds its optimal amount for forming NV centers in diamond, the excess nitrogen becomes an impurity. Phosphorus (P) is a dopant for producing n-type diamond. When the amount of phosphorus exceeds its optimum amount, the excess phosphorus becomes an impurity. The present invention can produce synthetic diamond in which the incorporation of such impurities exceeding the optimum amounts is suppressed.

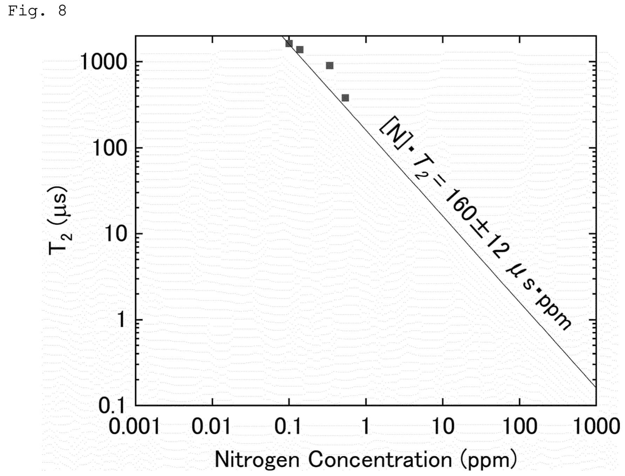

Fig. 8 is a graph explaining the correlation between the nitrogen concentration and the spin coherence time $T_2$ of NV centers in diamond. The measurement points in the graph are given by the present inventors.

According to recent studies described by J. F. Barry et al. in "Sensitivity optimization for NV-diamond magnetometry," Rev. Mod. Phys. 92, 68 (2020) (doi: https://doi.org/10.1103/ RevModPhys.92.015004) etc., the spin coherence time $T_2$ of NV centers is believed to be limited by the nitrogen concentration in the diamond. Empirically, a relationship given by the following equation is believed to exist between the nitrogen concentration, which is indicated by [N], and the spin coherence time, which is indicated by $T_2$:

$$[N] \cdot T_2 = 160 \pm 12 \ \mu s \cdot ppm \qquad \text{(Equation 1)}$$

Thus, suppression of the incorporation of nitrogen in particular among various impurities that are incorporated into diamond during synthesis is particularly expected to extend the spin coherence time $T_2$ of NV centers in synthetic diamond. This is expected to promote application of NV centers in quantum computing and as high-sensitivity quantum sensors etc.

As described above, conventionally, the incorporation of impurities into synthetic diamond has been suppressed by reducing the pressure in the reaction vessel to a relatively low pressure of 5 kPa to about 15 kPa (the low vacuum range approaching the medium vacuum range). The present inventors focused on the correlation between the nitrogen concentration and the spin coherence time $T_2$ in diamond, and arrived at the idea of reducing the amount of nitrogen in the air that flows into the reaction vessel due to air leakage during diamond synthesis. Then, the present inventors arrived at means of increasing the pressure in the reaction vessel compared to conventional methods so that the pressure reaches 15 kPa or higher and equal to or lower than atmospheric pressure (the low vacuum range approaching the atmospheric pressure).

Production of Synthetic Diamond

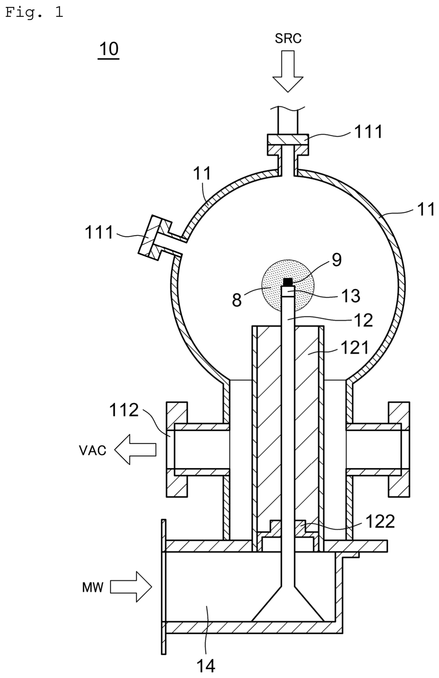

Fig. 1 is a cross-sectional view of a schematic structure of a CVD device used to produce synthetic diamond.

In the method for producing synthetic diamond according to an embodiment, a CVD device 10 shown in Fig. 1 is used to produce synthetic diamond. In the present embodiment, the CVD device 10 produces synthetic diamond by the microwave plasma CVD method.

The example CVD device 10 mainly includes a reaction vessel 11, an antenna 12, a substrate holder 13, and a waveguide 14.

In the reaction vessel 11, a feed gas (SRC) that is introduced into the vessel is converted into plasma and chemically activated, whereby a thin film of synthetic diamond is formed on the surface of a substrate 9 disposed inside. Preferably, the reaction vessel 11 is generally spherical and has dimensions that cause microwave resonance at a position where the substrate 9 is located.

The feed gas is introduced into the reaction vessel 11 through a port 111. A dopant gas can be optionally introduced into the reaction vessel 11. In the present embodiment, the feed gas is a gas mixture of methane ($CH_4$) and hydrogen ($H_2$), and the dopant gas is TBP gas, for example. The reactant gas inside the reaction vessel 11, which includes the feed gas and the dopant gas, is exhausted through an exhaust port 112. A vacuum pump (VAC) (not shown) is connected to the exhaust port 112, and the pressure inside the reaction vessel 11 is maintained at a predetermined level.

The antenna 12 supplies microwave (MW) transmitted from the waveguide 14 into the reaction vessel 11 and generates a plasma region 8 in the atmosphere of the feed gas around the substrate 9. An insulating material 121 is arranged around the antenna 12, excluding the tip of the antenna 12 in a coaxial manner with the antenna 12. In the present embodiment, discharge occurs selectively only at the tip of the antenna 12.

The substrate 9 is placed on the substrate holder 13 inside the reaction vessel 11. The substrate holder 13 is placed at the tip of the antenna 12. In the present embodiment, microwave is directly applied to the substrate 9 from the antenna 12 through the substrate holder 13. In order to maintain the sealing of the reaction vessel 11, a sealing member 122 is placed at the part where the internal space of the reaction vessel 11 and the internal space of the waveguide 14 are connected to each other.

The method for producing synthetic diamond according to the present invention is not limited to one for producing synthetic diamond by the example CVD device 10. The method for producing synthetic diamond according to the present invention can also produce synthetic diamond by another CVD device having a configuration different from that of the example CVD device 10.

Performance Evaluation

Although synthetic diamond has fewer crystal defects than natural diamond, NV centers are generated in diamond during diamond synthesis. In the present embodiment, the spin coherence time $T_2$ of NV centers in synthetic diamond formed on the substrate 9 is measured to evaluate the performance of the synthetic diamond produced.

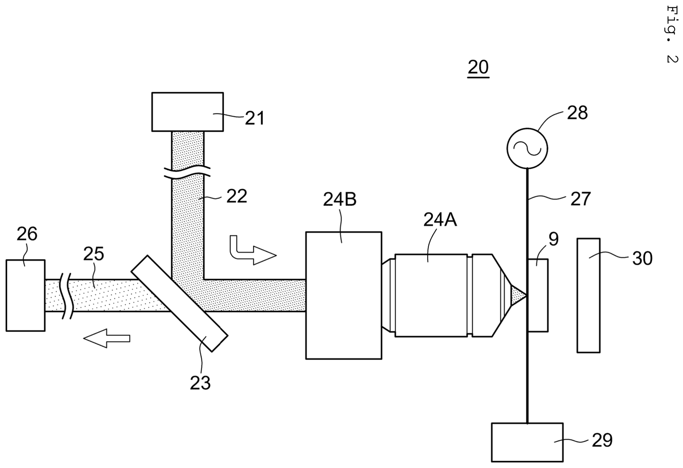

Fig. 2 shows a schematic structure of a measurement system used to evaluate NV centers in synthetic diamond.

NV centers in synthetic diamond formed on the substrate 9 can be evaluated according to the publicly known optically detected magnetic resonance (ODMR) method using a measurement system 20 shown in Fig. 2. For example, the measurement system 20 can be made by using a publicly known confocal fluorescence microscope.

In performing measurement according to the optically detected magnetic resonance (ODMR) method, a static magnetic field of about 30 gauss is applied to the substrate 9 by using a magnet 30 to define a quantization axis. Excitation light 22 output from an excitation light source 21 is used to cause NV centers to transition from a ground state to an excited state, and is laser light with a wavelength of 532 nm (green). The excitation light 22 is reflected by a dichroic mirror 23 and collected by an objective lens 24A; then, the substrate 9 is irradiated with the excitation light 22. If an NV center is present in the substrate 9, the NV center in a ground state transitions into an excited state and then relaxes to a ground state. When relaxing to a ground state, the NV center emits red fluorescence 25 with a wavelength of around 700 nm. The intensity of the emitted fluorescence 25 is measured by using a photodiode 26. Microwave MW is applied to the substrate 9 from a microwave source 28 by using a copper wire 27 (diameter: 30 $\mu$m). The frequency of the microwave MW being swept is measured by using a microwave detector 29. The optically detected magnetic resonance (ODMR) method can detect a magnetic resonance signal as the point at which the red fluorescence intensity has changed when the microwave frequency is swept at around 2.87 GHz.

A confocal image of the substrate 9 can be captured by using the photodiode 26. The position of the objective lens 24A is adjusted by a 3-axis piezoelectric stage 24B. This enables convergent beam irradiation of the excitation light 22 to different positions on the substrate 9.

Other Embodiments

Although the present invention is described above with reference to a particular embodiment, the invention is not limited to the embodiment described above.

In the embodiment described above, the CVD device 10 produces synthetic diamond by the microwave plasma CVD method. However, the CVD device used to produce synthetic diamond is not limited to one that produces synthetic diamond by the microwave plasma CVD method. The CVD device used to produce synthetic diamond is not limited as long as it can produce synthetic diamond by introducing a feed gas into the reaction vessel at a pressure equal to or lower than atmospheric pressure. In other words, the CVD device may be a CVD device that produces synthetic diamond, for example, by the direct current plasma CVD method, hot filament CVD method, arc discharge plasma jet CVD method, etc., instead of the microwave plasma CVD method described as an example in the above embodiment.

In addition to the embodiment described above, TBP, an n-type dopant gas, can be optionally introduced as a dopant gas into the reaction vessel 11. The dopant gas to be introduced into the reaction vessel 11 is not limited to TBP. Various dopant gases can be introduced into the reaction vessel 11, depending on the properties of diamond to be synthesized.

In the embodiment described above, the pressure in the reaction vessel is increased compared to conventional methods, whereby synthetic diamond is produced in which the incorporation of impurities exceeding the optimum amounts is suppressed. However, an impurity may be intentionally added depending on the purpose and application. For example, in the embodiment described above, TBP gas, a dopant gas containing phosphorus as a component, can be further introduced into the reaction vessel 11. Alternatively, nitrogen may be intentionally added as a dopant gas, for example, in order to generate multiple (more than one) NV centers, also known as an "ensemble system." This enables generation of more NV centers in synthetic diamond, which can be used in quantum sensors, for example. Such synthetic diamond with many NV centers makes it possible to improve the sensor sensitivity.

Examples of the present invention are given below to further clarify the features of the invention. Unless otherwise noted in the description of each Example, synthesis conditions, such as the device and feed gas used for synthesis, are the same between the Examples.

Example 1

In Example 1, diamonds were synthesized by gradually modifying synthesis conditions in order to suppress the incorporation of nitrogen due to air leakage. Table 1 shows the synthesis conditions. Synthetic diamonds were obtained under synthesis conditions 1 to 6 shown in Table 1.

Diamonds were synthesized by the microwave plasma CVD method using an example CVD device shown in Fig. 1. The feed gas to be introduced into the reaction vessel was a gas mixture of methane ($CH_4$) and hydrogen ($H_2$). Tertiary butyl phosphine (TBP: $P(C_4H_9)H_2$) gas was further introduced into the reaction vessel as an n-type dopant gas.

Table 1

| Synthesis conditions | Total flow rate [sccm] | $CH_4/H_2$ [%] | $TBP/CH_4$ [ppm] | Temp. [°C] | Pressure [kPa] |
|---|---|---|---|---|---|
| 1 | 100 | 0.1 | 26,500 | 700 - 900 | 25 |
| 2 | 100 | 1.0 | 0 (memory effect) | 900 - 1200 | 25 |
| 3 | 400 | 0.1 | 0 - 26,500 | 800 | 25 |
| 4 | 400 | 0.25 | 0 - 6,625 | 800 - 900 | 25 |
| 5 | 400 | 0.25 | 0 | 900 | 50 |
| 6 | 400 | 1.0 | 0 | 900 | 50 |

In synthesis conditions 3, the flow rate of the total reactant gas to be introduced into the reaction vessel was increased from 100 sccm in synthesis conditions 1 to 400 sccm in order to reduce the ratio of nitrogen in the reaction vessel. In synthesis conditions 5, the pressure in the reaction vessel was increased from 25 kPa in synthesis conditions 4 to 50 kPa in order to reduce the amount of nitrogen in the air that flows into the reaction vessel due to air leakage. As a result, the pressure difference between the pressure in the reaction vessel and the atmospheric pressure (about 101.3 kPa) was reduced. In synthesis conditions 6, the methane flow ratio was changed from 0.25% in synthesis conditions 5 to 1.0%.

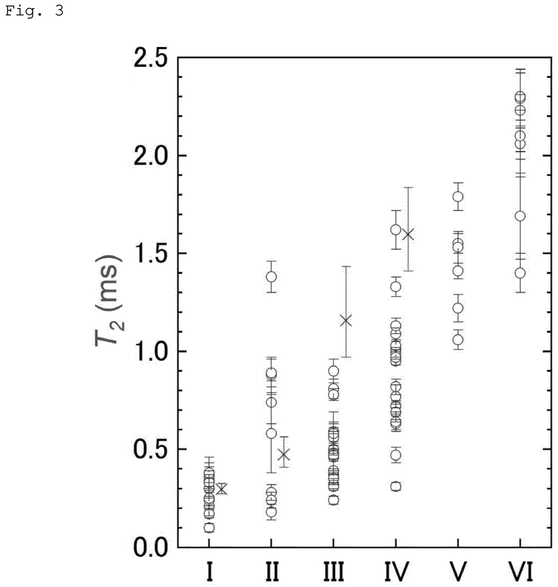

Synthetic diamonds were produced under synthesis conditions 1 to 6. For each NV center in the synthetic diamonds produced, the spin coherence time $T_2$ was measured using an example measurement system shown in Fig. 2. Fig. 3 and Table 2 show the measurement results. In the graph shown in Fig. 3, the plot symbols "○" (while circles) are measurements of the spin coherence time, and the plot symbols "×" are calculated values of the spin coherence time. The calculated values of the spin coherence time were obtained using an empirical relationship between the nitrogen concentration [N] and the spin coherence time $T_2$ represented by Equation 1 in the embodiment described above as well as the measurements of the nitrogen concentration obtained by the secondary ion mass spectrometry (SIMS) method. For synthesis conditions 5 and 6, the plot symbols "×" are not shown in Fig. 3 because the calculated values were significantly higher (about 4 ms) than the actual measurements.

Table 2

| Synthesis conditions | Maximum $T_2$ [ms] |
|---|---|
| 1 | 0.38 ± 0.05 |
| 2 | 0.90 ± 0.06 |
| 3 | 1.38 ± 0.08 |
| 4 | 1.62 ± 0.10 |
| 5 | 1.79 ± 0.07 |
| 6 | 2.23 ± 0.08 |

As shown in Fig. 3 and Table 2, the spin coherence time $T_2$ was gradually increased as the synthesis conditions were gradually modified. In synthesis conditions 3, in which the flow rate of the total reactant gas was increased to 400 sccm, the spin coherence time $T_2$ was about 1.38 milliseconds (ms). In synthesis conditions 5, in which the pressure in the reaction vessel was further increased to 50 kPa, the spin coherence time $T_2$ was about 1.79 ms. In synthesis conditions 6, in which the methane flow ratio was changed from 0.25% in synthesis conditions 5 to 1.0%, the spin coherence time $T_2$ was about 2.23 ms. As indicated by the plot symbols "○" and "×" in Fig. 3, a correlation was found between the maximum value of the measurements "○" and the calculated values "×" for the spin coherence time $T_2$, indicating that the nitrogen concentration is a factor that limits the spin coherence time $T_2$.

As described above, NV centers with a spin coherence time $T_2$ of one millisecond or longer were formed in Example 1. The spin coherence time $T_2$ of one millisecond or longer under synthesis conditions 3 to 5 shown in Table 2 was the longest achieved at room temperature so far. It was confirmed that synthetic diamonds having NV centers with such a long spin coherence time $T_2$ can be constantly produced under conditions 3 to 5.

Example 2

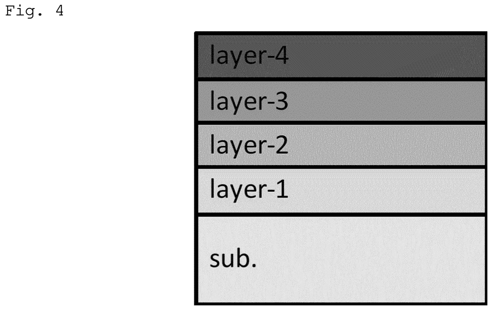

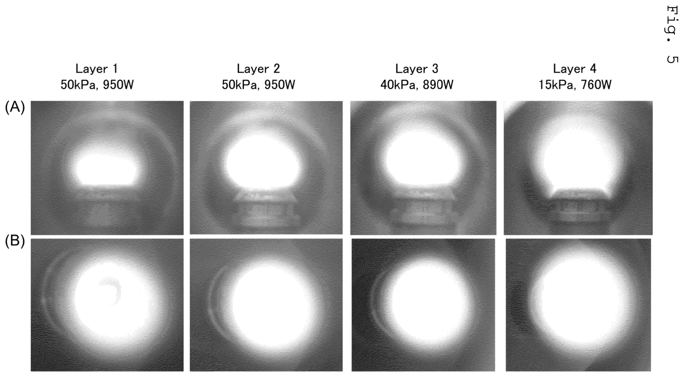

In Example 2, the dependence of the pressure in the reaction vessel on synthesis conditions was investigated. First, as a sample, four layers (layer-1 to layer-4) of synthetic diamond were formed on the substrate as shown in Fig. 4 while changing the pressure in the reaction vessel among synthesis conditions. Table 3 shows the synthesis conditions of each layer. Table 4 shows the synthesis rate based on weight estimation of each layer. Fig. 5 shows images of the inside of the reaction vessel that were captured during formation of the four layers of the synthetic diamond.

Table 3

| Layer No. | Total FR [sccm] | $H_2$ [sccm] | 12C-$CH_4$ [sccm] | TBP/$H_2$ [sccm] | $CH_4$/$H_2$ [%] | TBP/$CH_4$ [ppm] | Pressure [kPa] | Temp.[°C] (target) | Time [hours] |
|---|---|---|---|---|---|---|---|---|---|
| 1 | 400 | 400 | 1.0 | 0 | 0.25 | 0 | 50 | 900 | 2 |
| 2 | 400 | 400 | 1.0 | 0.4 | 0.25 | 1060 | 50 | 900 | 2 |
| 3 | 400 | 400 | 1.0 | 0.4 | 0.25 | 1060 | 40 | 900 | 2 |
| 4 | 400 | 400 | 1.0 | 0.4 | 0.25 | 1060 | 15 | 900 | 2 |

Table 4

| Layer No. | Synthesis rate based on weight estimation [μm] | Synthesis rate corrected based on SIMS comparison [μm]** |
|---|---|---|
| 1 | 2.43 | 0.97 |

(continued)

| Layer No. | Synthesis rate based on weight estimation [μm] | Synthesis rate corrected based on SIMS comparison [μm]** |
|:---:|:---:|:---:|
| 2 | 3.12 | 1.25 |
| 3 | 2.55* | 1.02 |
| 4 | 1.38* | 0.55 |

Table 4 shows the synthesis rate based on weight estimation from the past synthesis results. In Table 4, the values marked with the symbol "*" are values obtained with TBP/H2 = 0 [sccm], and the values in the column marked with the symbol "**" are the values of weight estimation/2.5.

In Fig. 5, the images in the upper row (A) are sideview images of the substrate placed in the reaction vessel. The images in the bottom row (B) are top-view images of the substrate placed in the reaction vessel. The numerical value indicated by the unit watt [W] in Fig. 5 is the plasma output (microwave output). As is confirmed in Fig. 5, the density of plasma generated near the substrate was reduced when the pressure in the reaction vessel was reduced to 15 kPa, which is the same level as in conventional methods, during formation of layer-4 of the synthetic diamond. When the pressure in the reaction vessel was lowered while maintaining the microwave output at the same level, the generated plasma had a larger diameter. This, in turn, raised the substrate temperature, so the microwave output had to be reduced in order to match the target substrate temperature.

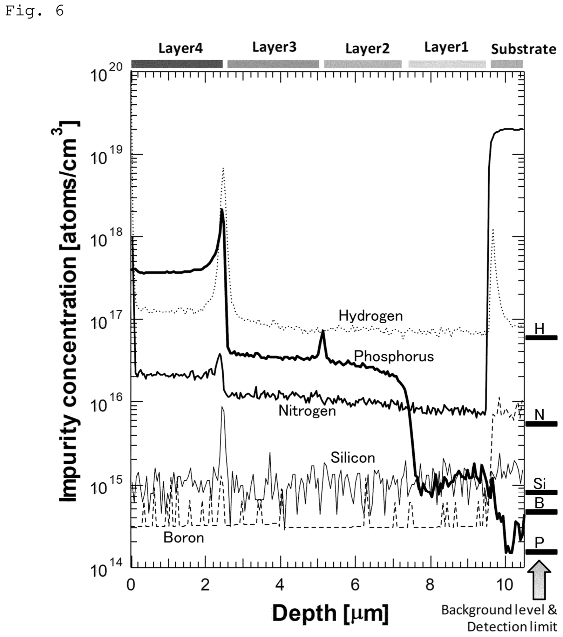

Next, the sample obtained by forming four layers of the synthetic diamond was analyzed by the secondary ion mass spectrometry (SIMS) method, and the impurity concentration in each of the four layers of the synthetic diamond was quantitatively measured. Fig. 6 shows the measurement results. Table 5 shows the film thickness and growth rate of each layer. Table 6 shows the impurity concentration in each layer. Regarding Table 5, the total thickness of the four layers of the synthetic diamond formed on the substrate was 9.67 μm, and the growth rate during synthesis of the four layers was 1.21 μm/hour. Regarding Table 6, the impurity concentration measurements of boron (B) and silicon (Si) were equal to or below the background measurements by the SIMS method.

Table 5

| Layer No. | Thickness [μm] | Growth rate [μm/hour] |
|:---:|:---:|:---:|
| 1 | 2.16 | 1.08 |
| 2 | 2.37 | 1.18 |
| 3 | 2.68 | 1.34 |
| 4 | 2.46 | 1.23 |

Table 6

| | Impurity concentration [cm$^{-3}$] | | | |
|:---:|:---:|:---:|:---:|:---:|
| | Layer 1 | Layer 2 | Layer 3 | Layer 4 |
| [P] | $1.2\times10^{15}$ | $2.6\times10^{16}$ | $3.5\times10^{16}$ | $3.9\times10^{17}$ |
| [N] | $7.6\times10^{15}$ | $9.6\times10^{15}$ | $1.2\times10^{16}$ | $2.1\times10^{16}$ |
| [H] | $6.9\times10^{16}$ | $7.4\times10^{16}$ | $8.3\times10^{16}$ | $1.2\times10^{17}$ |

The measurement results obtained by the SIMS method shown in Fig. 6 and Table 6 are examined here. In Example 2, as shown in Table 3, the pressure in the reaction vessel was reduced from 50 kPa to 15 kPa over the period of formation of layer-1 to layer-4 of the synthetic diamond. As shown in Fig. 6 and Table 6, the concentrations of impurities, i.e., nitrogen (N), hydrogen (H), and phosphorus (P), were relatively high in layer-4, in which the pressure in the reaction vessel was reduced to 15 kPa, which is the same level as in conventional methods, compared to layer-1 to layer-3. An increase in concentrations of nitrogen, hydrogen, and phosphorus was found from layer-3 to layer-4, in which the pressure in the reaction vessel was reduced from 40 kPa to 15 kPa. In particular, phosphorus showed a significant increase in concentration. A significant increase in phosphorus concentration was also found from layer-1 to layer-2, in which TBP, an n-type dopant gas, was introduced into the reaction vessel.

As described above, it was quantitatively confirmed based on the measurement results by the SIMS method shown in Fig. 6 and Table 6 that when the pressure in the reaction vessel was maintained at a higher level, the concentrations of the impurities, i.e., nitrogen, hydrogen, and phosphorus, in the synthetic diamond were more reduced. The present measurement results were obtained from the four layers of the synthetic diamond formed while changing the pressure in the reaction vessel. As shown in the images in Fig. 5, these measurement results were obtained when the microwave output was adjusted such that the substrate temperature during formation of each layer would match the target temperature (900°C).

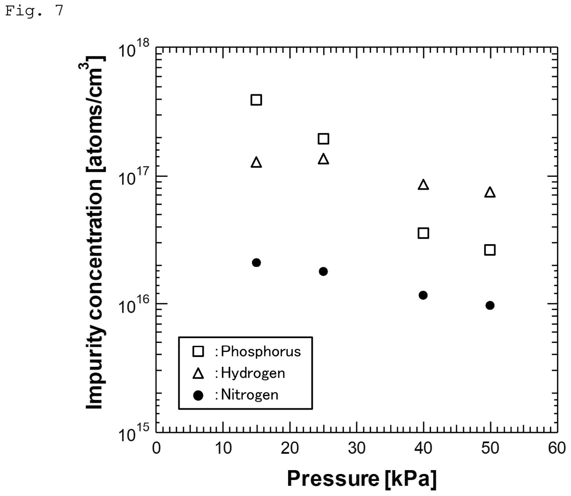

Next, a layer of synthetic diamond was formed with a pressure in the reaction vessel of 25 kPa, which is different from the pressure shown in Table 3, to form a sample different from the above sample. The impurity concentration in this different sample was also measured by the SIMS method to supplement the measurement result data shown in Fig. 6 and Table 6. Based on the supplemented measurement result data, the graph shown in Fig. 7 was created.

Fig. 7 shows the graph obtained by plotting the measurement results of the concentration of each impurity in the synthetic diamond for each pressure in the reaction vessel during diamond synthesis. In the graph shown in Fig. 7, the plot symbols "□" (white squares) each indicate the phosphorus concentration, the plot symbols "∆" (white triangles) each indicate the hydrogen concentration, and the plot symbols "•" (black circles) each indicate the nitrogen concentration. Table 7 shows the synthesis conditions under which the synthetic diamond layer with the measurement results shown in Fig. 7 was produced.

Table 7

| Total FR [sccm] | $H_2$ [sccm] | 12C-$CH_4$ [sccm] | TBP/$H_2$ [sccm] | $CH_4$/$H_2$ [%] | TBP/$CH_4$ [ppm] | Pressure [kPa] | Temp.[°C] (target) |
|---|---|---|---|---|---|---|---|
| 400 | 398.6 | 1.0 | 0.4 | 0.25 | 1060 | 15-50 | 900 |

With reference to Fig. 7, the dependence of the pressure in the reaction vessel on the synthesis conditions was examined. The examination confirmed a gradual reduction in concentration of each of the elements acting as impurities (i.e., nitrogen, hydrogen, and phosphorus) in the synthetic diamond over the pressure change from 15 kPa to 50 kPa.

Description of the Reference Numerals

8       plasma region

9       substrate

10      CVD device

11      reaction vessel

111     port

112     exhaust port

12      antenna

121     insulating material

122     sealing member

13      substrate holder

14      waveguide

20      measurement system

21      excitation light source

22      excitation light

23      dichroic mirror

24A     objective lens

24B     piezoelectric stage

25      fluorescence

25      kPa pressure

26      photodiode

27      wire

28      microwave source

29      microwave detector

30      magnet

**Claims**

1. A method for producing synthetic diamond by chemical vapor deposition, the method comprising:

   an introduction step of introducing a feed gas into a reaction vessel; and
   an activation step of chemically activating the feed gas,
   wherein the pressure in the reaction vessel during the activation step is 15 kPa or higher and equal to or lower than atmospheric pressure.

2. The method for producing synthetic diamond according to claim 1, wherein in the introduction step, the total reactant gas to be introduced into the reaction vessel, including the feed gas, is introduced into the reaction vessel at a total flow rate of higher than 100 sccm.

3. The method for producing synthetic diamond according to claim 1, wherein the pressure in the reaction vessel during the activation step is 15 kPa or higher and 60 kPa or lower.

4. The method for producing synthetic diamond according to claim 1, wherein the activation step includes generating a plasma region in the atmosphere of the feed gas.

5. The method for producing synthetic diamond according to claim 1, further comprising a dopant gas introduction step of introducing a dopant gas into the reaction vessel, the dopant gas containing phosphorus or nitrogen as a component.

6. A sensor element comprising synthetic diamond produced by the method according to any one of claims 1 to 5, the synthetic diamond containing one or more nitrogen-vacancy centers in a crystal structure thereof.

Fig. 1

Fig. 2

Fig. 3

Fig. 4

| |
|---|
| layer-4 |
| layer-3 |
| layer-2 |
| layer-1 |
| sub. |

Fig. 5

Fig. 6

Fig. 7

Fig. 8

## INTERNATIONAL SEARCH REPORT

| International application No. |
|---|
| **PCT/JP2024/002371** |

### A.    CLASSIFICATION OF SUBJECT MATTER

*C30B 29/04*(2006.01)i; *C23C 16/27*(2006.01)i; *C23C 16/511*(2006.01)i; *C30B 25/02*(2006.01)i
FI:    C30B29/04 E; C23C16/27; C30B25/02 P; C23C16/511

According to International Patent Classification (IPC) or to both national classification and IPC

### B.    FIELDS SEARCHED

Minimum documentation searched (classification system followed by classification symbols)

C30B29/04; C23C16/27; C23C16/511; C30B25/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JMEDPlus/JST7580 (JDreamIII)

### C.    DOCUMENTS CONSIDERED TO BE RELEVANT

| Category* | Citation of document, with indication, where appropriate, of the relevant passages | Relevant to claim No. |
|---|---|---|
| X | HERBSCHLEB, E.D. et al. Ultra-long coherence times amongst room-temperature solid-state spins. Nature Communications. 2019, vol. 10, pp. 1-6, https://doi.org/10.1038/s41467-019-11776-8<br>pp. 2-6 | 1-6 |
| X | JP 2021-080153 A (SHIN-ETSU CHEMICAL CO., LTD.) 27 May 2021 (2021-05-27)<br>paragraphs [0005], [0065]-[0072], [0100]-[0117] | 1-6 |
| X | JP 2016-537287 A (ELEMENT SIX TECHNOLOGIES LIMITED) 01 December 2016 (2016-12-01)<br>paragraphs [0043]-[0055] | 1-4, 6 |
| A | | 5 |

☐ Further documents are listed in the continuation of Box C.        ☑ See patent family annex.

| | | | |
|---|---|---|---|
| \* | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **05 April 2024** | **16 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

EP 4 656 778 A1

## INTERNATIONAL SEARCH REPORT
### Information on patent family members

International application No.

**PCT/JP2024/002371**

| Patent document cited in search report | | | Publication date (day/month/year) | Patent family member(s) | | | Publication date (day/month/year) |
|---|---|---|---|---|---|---|---|
| JP | 2021-080153 | A | 27 May 2021 | US | 2021/0148005 | A1 | |
| | | | | paragraphs [0005], [0082]-[0094], [0122]-[0139] | | | |
| | | | | US | 2023/0250553 | A1 | |
| | | | | EP | 3822396 | A2 | |
| | | | | CN | 112813409 | A | |
| | | | | KR | 10-2021-0060357 | A | |
| | | | | TW | 202120731 | A | |
| JP | 2016-537287 | A | 01 December 2016 | US | 2017/0009376 | A1 | |
| | | | | paragraphs [0065]-[0097] | | | |
| | | | | US | 2021/0395916 | A1 | |
| | | | | GB | 2526639 | A | |
| | | | | WO | 2015/071484 | A1 | |
| | | | | EP | 3071728 | A1 | |

Form PCT/ISA/210 (patent family annex) (July 2022)

20

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009196832 A

**Non-patent literature cited in the description**

- **J. F. BARRY et al.** Sensitivity optimization for NV-diamond magnetometry. *Rev. Mod. Phys.*, 2020, vol. 92, 68